Europäisches Patentamt

European Patent Office

Office européen des brevets

(19)

(11) Veröffentlichungsnummer: **0 005 739**
**B1**

(12)

# EUROPÄISCHE PATENTSCHRIFT

(45) Veröffentlichungstag der Patentschrift: **01.09.82**

(51) Int. Cl.³: **H 01 L 49/02**

(21) Anmeldenummer: **79101336.0**

(22) Anmeldetag: **02.05.79**

(54) Verfahren zur Herstellung von Leiterbahnüberkreuzungen für integrierte RC-Netzwerke.

(30) Priorität: **31.05.78 DE 2823881**

(43) Veröffentlichungstag der Anmeldung:
**12.12.79 Patentblatt 79/25**

(45) Bekanntmachung des Hinweises auf die Patenterteilung:
**01.09.82 Patentblatt 82/35**

(84) Benannte Vertragsstaaten:
**BE FR IT LU NL SE**

(56) Entgegenhaltungen:
**FR - A - 2 065 090**
**US - D - 231 416**

(73) Patentinhaber: **SIEMENS AKTIENGESELLSCHAFT**
**Berlin und München**
**Postfach 22 02 61**
**D-8000 München 22 (DE)**

(72) Erfinder: **Münz, Wolf-Dieter, Dr.**
**Im Schwalbengrund 25**
**D-6463 Freigericht (DE)**
Erfinder: **Pötzlberger, Hans-Werner, Dipl.-Ing.**
**Steinstrasse 8**
**D-8000 München 80 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Verfahren zur Herstellung von Leiterbahnüberkreuzungen für integrierte RC- Netzwerke

In der DE—C 26 53 814 ist ein Verfahren zur Herstellung einer elektrischen Dünnschichtschaltung beschrieben, die zumindest einen Kondensator und eine Leiterbahn und/oder einen Widerstand umfaßt, bei welchem zur Bildung dieser Schaltelemente auf ein isolierendes Substrat zunächst eine Schicht einer Tantal-Aluminium-Legierung mit einem Tantalanteil zwischen 30 und 70 Atom-% (in der Folge als TaAl I bezeichnet) und darauf eine weitere Schicht einer Tantal-Aluminium-Legierung mit einem Tantalanteil in der Größenordnung zwischen 2 und 20 Atom-% (TaAl II) aufgebracht wird, dann mittels einer ersten Masken- und Ätztechnik an der Stelle eines zu bildenden Kondensators eine Unterbrechung in beide Tantal-Aluminium-Schichten eingebracht wird, worauf zur Erzeugung eines zweischichtigen Kondensator-Dielektrikums die Tantal-Aluminium-Schichten anodisch oxidiert und auf die resultierende Tantal-Aluminium-Oxidschicht eine Silizium-Dioxidschicht aufgebracht wird, dann mittels eines weiteren fotolithografischen Ätzschrittes die dielektrischen Schichten strukturiert werden und schließlich eine gut leitfähige Schicht aufgebracht und mit einem weiteren fotolithografischen Ätzschritt strukturiert wird.

Das dem obigen Patent zugrundeliegende Problem besteht darin, für elektrische Dünnschichtschaltungen einen Weg aufzuzeigen, der eine weitere Reduzierung der für die Herstellung der Dünnschichtschaltungen insgesamt benötigten Masken ermöglicht. Die Lösung gemäß dem obenbenannten Patent besteht darin, daß bei einem Verfahren der einleitend geschilderten Art mit Hilfe der ersten Masken- und Ätztechnik zusätzlich die außerhalb der Schaltelementbereiche liegenden Bereiche beider Tantal-Aluminium-Schichten abgeätzt werden, daß dann die freiliegenden Oberflächen der Tantal-Aluminium-Schichten ganzflächig anodisch oxidiert und mit der ganzflächig aufgebrachten Silizium-Dioxid-Schicht überzogen werden, daß die nicht benötigten Bereiche der Silizium-Dioxidschicht mit Hilfe einer zweiten Masken- und Ätztechnik entfernt und die nicht benötigten Bereiche der Tantal-Aluminium-Oxidschicht und der Tantal-Aluminium-Schicht mit dem niedrigen Tantalgehalt unter Verwendung der verbleibenden Silizium-Dioxidschicht als Ätzmaske selektiv abgeätzt werden und daß anschließend die Oberflächenschicht aufgebracht wird.

Zur Komplettierung der elektrischen Schaltungen mit Hilfe der Dünnfilmtechnik sind zumeist Einbauplätze für Hybridbauelemente vorgesehen, welche in gesonderten Arbeitsschritten mit der DF-Schaltung verbunden werden. Aus wirtschaftlichen Gründen wird immer eine optimale Flächenausnützung der DF-Schaltung angestrebt. Deren Abmessungen werden im wesentlichen bestimmt durch technologiebedingte Eigenschaften (Flächenwiderstand, Flächenkapazität der Kondensatoren) und durch die für diese Schaltung notwendige Verdrahtung der DF-Bauelemente untereinander und mit den nach außen führenden Anschlüssen.

Leiterbahnüberkreuzungen sind aus einer ersten, "unteren" elektrisch leitenden, einer elektrisch isolierenden und einer zweiten, "oberen" elektrisch leitenden Schicht oder Schichtfolge aufgebaut. Durch entsprechende Strukturierung erhält man senkrecht zur Substratoberfläche gesehen Kreuzungsstellen von zwei voneinander elektrisch isolierten Leiterbahnen, die als Leiterbahnüberkreuzungen bezeichnet werden. Diese können bekanntlich auf verschiedene Arten realisiert werden.

Die aus der US—PS 3 949 275 (DE—OS 2 331 586) bekannte TaAl-Doppelschichttechnik gestattet die Herstellung von TaAl-Widerständen und TaAl-Oxid-Kondensatoren auf einem Substrat. Durch die Einführung eines Sandwich-Dielektrikums bestehend aus TaAl-Oxid und $SiO_2$ bestimmter Schichtdicken können die Temperaturkoeffizienten von Widerständen und Kondensatoren kompensiert werden, wie es in der DE—OS 2 506 065 beschrieben ist. Ein Herstellverfahren dazu ist in der deutschen Patentanmeldung P 26 53 814.7 beschrieben.

Aus der US—A—B 231 416 ist ein Verfahren zur Herstellung von Leiterbahnüberkreuzungen geringer Kapazität in einer elektrischen Dünnschichtschaltung bekannt, bei dem auf ein isolierendes Substrat eine Ta-Schicht aufgebracht und durch einen fotolithografischen Ätzschritt in Widerstände, eine eine untere Kondensatorelektrode enthaltende untere Leiterbahn und in eine senkrecht dazuliegende Leiterbahn als Anschluß für eine obere Kondensatorelektrode strukturiert wird, bei dem anschließend nach Entfernen der Fotolackmaske eine dielektrische Schicht aufgebracht und strukturiert wird, so daß zumindestens die untere Kondensatorelektrode von der dielektrischen Schicht überdeckt bleibt, und bei dem eine Leiterbahnschicht aufgebracht und strukturiert wird, wobei die obere Kondensatorelektrode als Teil einer überkreuzenden Leiterbahn ausgebildet wird.

Der Erfindung liegt die Aufgabe zugrunde, Leiterbahnüberkreuzungen in RC-Netzwerke zu integrieren. Nach der Erfindung besteht die Lösung in einem Verfahren zu Herstellung von Leiterbahnüberkreuzungen geringer Kapazität in einer elektrischen Dünnschichtschaltung, bei dem auf ein isolierendes Substrat eine TaAl-Doppelschicht, deren untere TaAl-Schicht gegenüber der oberen TaAl-Schicht einen höheren Ta-Gehalt aufweist, aufgebracht und durch einen ersten fotolithografischen Ätzschritt in Widerstände, in eine eine untere Kondensatorelektrode enthaltende untere Leiterbahn und in eine senkrecht dazu liegende Leiterbahn als Anschluß für eine obere Kondensatorelektrode strukturiert wird, bei dem anschließend nach entfernen der ersten Fotolackmaske eine dielektrische Schicht aufgebracht und mit einem zweiten lithografischen Ätzschritt strukturiert wird, so daß zumindest die untere Kondensatorelektrode von der dielektrischen Schicht überdeckt bleibt, bei dem anschließend mit Hilfe der strukturierten dielektrischen Schicht als Maske die freiliegenden Teile der oberen TaAl-Schicht abgeätzt werden, und bei dem darauf eine Leiterbahnschicht ganzflächig aufgebracht und mit Hilfe eines dritten fotolithografischen Ätzschrittes strukturiert wird, wobei die obere Kondensatorelektrode als Teil einer überkreuzenden Leiterbahn ausgebildet wird. Auf diese Weise ist es möglich, unter Anwendung der TaAl/SiO$_2$-RC-Technologie z. B. aktive Filternetzwerke mit integrierten Leiterbahnüberkreuzungen sehr wirtschaftlich herzustellen, da kein zusätzlicher Prozeß erforderlich ist und durch die Integration der Leiterbahnüberkreuzungen die Schaltungsgröße verringert werden kann. Für bestimmte Schaltungstypen ist unter Umständen der Einbau von Leiterbahnüberkreuzungen unumgänglich notwendig. In solchen Fällen wird durch die Erfindung ein kostenaufwendiges Hybridier-Verfahren (z. B. Bonden) vermieden.

Das Verfahren nach der Erfindung kann beispielsweise darin bestehen, daß die untere Leiterbahn durch die vollkommen mit der unteren TaAl-Schicht unterlegten Leiterbahnschicht, die vorzugsweise aus Ti Pd Au besteht, und einem Stück der TaAl-Doppelschicht im Überkreuzungsbereich gebildet wird und daß die überkreuzende Leiterbahn aus dem ebenfalls mit der unteren TaAl-Schicht unterlegten Leiterbahnschicht außerhalb und einem Stück der Leiterbahnschicht im Überkreuzungsbereich aufgebaut ist. Auf diese Weise erhält man eine sehr flexible Schaltungsauslegung. Man kann nämlich mehr vernetzte Lay-outs unterbringen. Im Falle von 100 $\mu$m breiten Leiterbahnstrukturen ergibt sich mit der Flächenkapazität von 10 nF/cm$^2$ eine Kapazität von 1 pF zwischen den sich kreuzenden Leiterbahnen der Leiterbahnüberkreuzung.

In einer weiteren besonderen Ausführungsart der Erfindung wird die dielektrische Schicht durch anodische Oxidation der strukturierten Oberfläche der TaAl-Doppelschicht und anschließendes ganzflächiges Aufbringen einer SiO$_2$-Schicht hergestellt und durch einen fotolithografischen Ätzprozeß strukturiert. Dadurch wird erreicht, daß die unterkreuzende Leiterbahn, die im Überkreuzungsbereich durch die elektrisch sehr gut leitfähige TaAl-Doppelschicht gebildet wird, durch die Isolierschichten anodisches Oxid und SiO$_2$ vom elektrisch sehr gut leitfähigen Material der überkreuzenden Leiterbahn (TiPdAu) getrennt ist.

Nach einer Weiterbildung der Erfindung kann durch ein spezielles Verfahren die Kapazität der überkreuzenden Leiterbahn auf ca. 0,1 pF erniedrigt werden, wenn vor dem Strukturieren eine zusätzliche dielektrische Schicht, vorzugsweise aus Polyimid, aufgebracht wird. Dieses Polyimid kann z. B. im Siebdruckverfahren im Überkreuzungsbereich aufgebracht werden oder kann als fotovernetzbarer Film aufgebracht und strukturiert werden. Bei dieser Variante 2 entsprechen die vorausgegangenen und die nachfolgenden Prozesse denen von Variante 1. Der Vorteil dieses Verfahrens besteht darin, daß die Kapazität der Leiterbahnüberkreuzungen ca. um den Faktor 10 verringert wird. Es bietet sich das Siebdruckverfahren wegen seiner einfachen Handhabung an. Die Zuverlässigkeit wird dadurch noch erhöht.

Bisher wurden Lösungen angegeben, wie Leiterbahnüberkreuzungen in temperaturkompensierte TaAl/SiO$_2$-RC-Netzwerke integriert werden können. Es lassen sich auch Anwendungen für nicht temperaturkompensierte RC-Schaltungen oder reine R-Netzwerke ausführen, wo ebenfalls Leiterbahnüberkreuzungen integriert werden sollen. Unter Anwendung der TaAl-Doppelschichttechnik in Verbindung mit einer Polyimid-Isolierschicht sind für diese speziellen Fälle nach der Erfindung zwei weitere Varianten 3 und 4 zur Herstellung von Leiterbahnüberkreuzungen möglich.

Für nicht temperaturkompensierte TaAl-RC-Netzwerke wird demnach der RC-Prozeßablauf ohne SiO$_2$-Dielektrikum durchgeführt, wobei die Isolierschicht aus TaAl-Oxid-Polyimid besteht (Variante 3). Auf diese Weise ist es möglich, die Kondensatoren wesentlich dichter anzuordnen, weil mit TaAl-Oxid als Dielektrikum die Kondensatoren kleiner werden.

Nach einer weiteren Ausgestaltung der Erfindung kann für reine Widerstandsnetzwerke zur Integrierung von Leiterbahnüberkreuzungen nach dem Aufbringen und Strukturieren der TaAl-Doppelschicht die Beschichtung mit Polyimid an den Überkreuzungsstellen erfolgen, so daß die Isolierschicht in diesem Fall allein als Polyimid besteht. Das Abätzen der TaAl II-Schicht im Bereich von Widerständen kann hier nach dem Aufbringen und Strukturieren der Leiterbahnschicht erfolgen, die dann außerhalb der Überkreuzungsbereiches mit der TaAl-Doppelschicht unterlegt sind. Durch den Wegfall von hier nicht benötigten Dünnfilmkondensatoren wird der Herstellungsprozeß ver-Zusammenfassend kann festgestellt werden, daß die vier Ausführungsbeispiele der Erfindung die Integration von Leiterbahnüberkreuzungen in temperaturkompensierten sowie in nicht temperaturkompensierten RC-Netzwerken als auch in Dünnfilm-R-Netzwerken ermöglichen. Die Anwendung der TaAl-Doppelschichttechnik in Verbindung mit der TaAl-SiO$_2$-Technologie, die für temperaturkompensierte RC-Netzwerke eingesetzt wird, wird dadurch noch attracktiver.

Die Erfindung wird anhand der Figuren erläutert. Es zeigen:

Fig. 1 den Herstellungsablauf von TaAl/SiO$_2$- (Variante 1) und TaAl/SiO$_2$-Polyimid- (Variante 2) -Leiterbahnüberkreuzungen,

Fig. 2 den Herstellungsablauf von Leiterbahnüberkreuzungen nach Variante 3 und 4 und

Fig. 3 einen prinzipiellen Aufbau der Leiterbahnüberkreuzung (mit integriertem Widerstand) für die Varianten 1 bis 4.

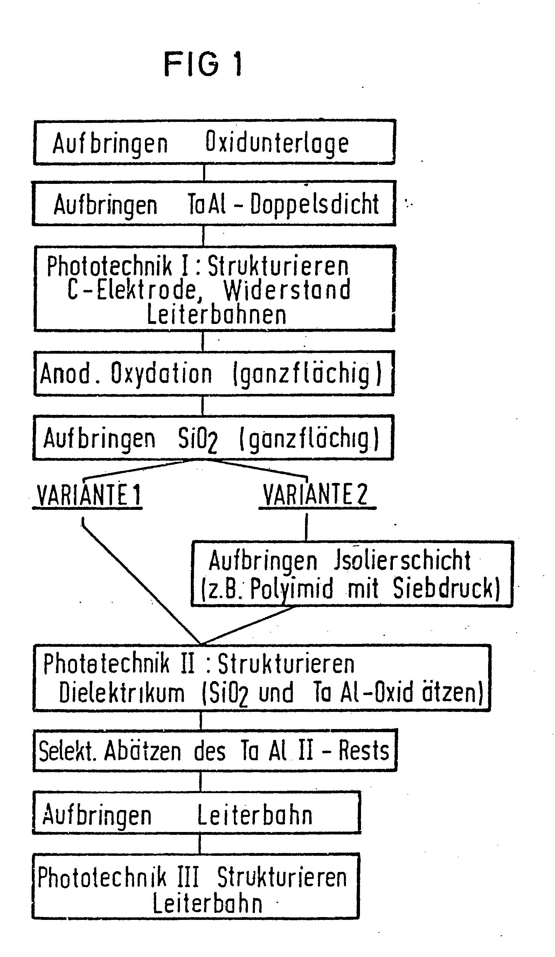

Gemäß Figur 1 ist als Ausgangsbasis eine isolierende Unterlage vorgesehen, welche z. B. durch Aufbringen eines Oxyds auf einen nichtleitenden Träger hergestellt werden kann. Auf diese Unterlage wird eine TaAl-Doppelschicht aufgebracht. Das Aufbringen der Tantal-Aluminium-Legierungsschicht erfolgt in an sich bekannter Weise, beispielsweise mittels Kathodenzerstäubung.

Die so vorbereitete Unterlage wird nun mit einer Maske bedeckt, welche beispielsweise fotolithographisch mit Hilfe eines positiv wirkenden Fotolackes hergestellt werden kann. Diese Maskenherstellung ist mit Fototechnik I bezeichnet. Die Maske deckt sämtliche der den zu erzeugenden Kondensator-Grundelektroden, Widerständen und Leiterbahnen entsprechenden Bereiche ab, so daß die übrigen Bereiche der Tantal-Aluminium-Legierungsschicht durch einen Ätzschritt oder durch zwei aufeinanderfolgende Ätzschritte abgeätzt werden können. Bei zwei aufeinanderfolgenden selektiven Ätzschritten wird eine Unterätzung der Tantal-Aluminium-Legierungsschicht vermieden.

Nach der Entfernung der durch die Fototechnik I gebildeten Maske wird eine ganzflächige anodische Oxydation vorgenommen, bei welcher der Oberflächenbereich der Tantal-Aluminium-Legierungsschicht in eine Tantal-Aluminium-Oxydschicht vorzugsweise auch über die an den Kondensator-bereich anschließenden Unterbrechung erstreckt sich die Tantal-Aluminium-Oxydshicht vorzugsweise auch über die freie Stirnseite der Tantal-Aluminium-Legierungsschicht. Nach der anodischen Oxydation wird auf die Unterlage ganzflächig eine Silizium-Dioxyschicht vorzugsweise mittels Kathodenzerstäubung aufgebracht.

Bei der Variante 1 folgt an dieser Stelle sofort die Fototechnik II, während bei der Variante 2 noch eine Isolierschicht, z. B. Polyimid, mittels Siebdruck aufgebracht wird. Von dieser Ausnahme abgesehen verläuft der Herstellungsablauf für die Varianten 1 und 2 wieder gemeinsam, und zwar wird eine zweite Maske aufgebracht, welche vorzugsweise fotolithographisch mit Hilfe eines positiv wirkenden Fotolackes hergestellt wird. Diese Maskenherstellung ist mit Fototechnik II bezeichnet. Die zweite Maske deckt den Dielektrikumsbereich der zu erzeugenden Kondensatoren ab, so daß die übrigen Bereiche der Silizium-Dioxydschicht und der Tantal-Aluminium-Oxydschicht durch zwei aufeinanderfolgende selektive Ätzschritte abgeätzt werden können. Die Strukturierung der Silizium-Dioxyd-Schicht kann auch naß-chemisch vorgenommen werden, erfolgt aber vorzugsweise durch Plasma-Ätzen. Eine entsprechende Strukturierung der Tantal-Aluminium-Oxydschicht erfolgt nach Entfernung der zweiten Fotomaske naß-chemisch. Bei diesem Ätzvorgang dient die verbliebene Silizium-Dioxydschicht als Ätzmaske.

Nach diesem Ätzvorgang werden in einem weiteren selektiven Ätzvorgang die für die Kondensator-Grundelektroden nicht benötigten Restbereiche der Tantal-Aluminium-Legierungsschicht abgeätzt, wobei die verbliebene Silizium-Dioxydschicht wieder als Ätzmaske dient.

Im folgenden Verfahrensschritt wird zur Bildung der Leiterbahnen und der Kondensator-Gegenelektroden ganzflächig eine elektrisch gut leitende vorzugsweise aus Ti, Pd, Au bestehende Lieterbahnschicht aufgebracht. Diese Leiterbahnschicht kann auch beispielsweise durch nacheinander erfolgendes Aufdampfen einer Nickel-Chrom-Schicht und einer Gold-Schicht hergestellt werden.

Im Letzten Verfahrensschritt wird die Oberflächenschicht strukturiert. Hierzu wird auf die Gold-Schicht eine dritte Maske aufgebracht, welche beispielsweise fotolithographisch mit Hilfe eines positiv wirkenden Fotolackes hergestellt wird. Diese Maskenherstellung ist mit Fototechnik III bezeichnet. Die dritte Maske deckt die Bereiche der Leiterbahnen und der Kondensator-Gegenelektroden ab, so daß die übrigen Bereiche der Leiterbahnschicht abgeätzt werden können. Nach diesen selektiven Ätzvorgängen braucht zur Fertigstellung der Dünnschichtschaltung nur noch die dritte Maske entfernt zu werden.

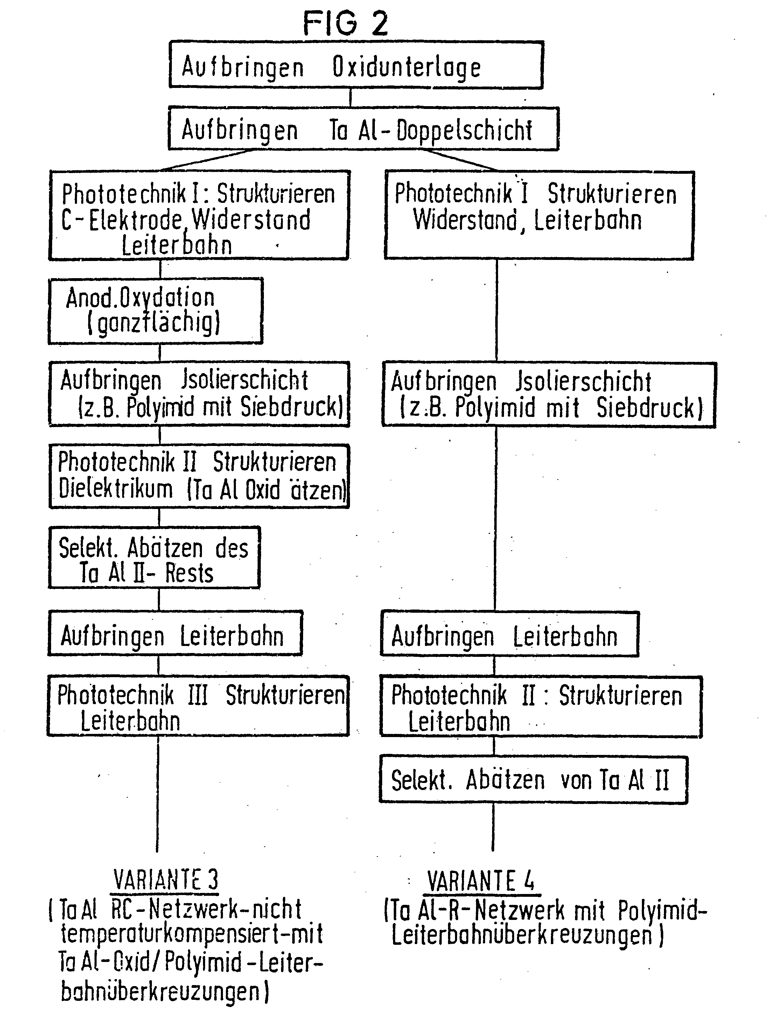

Der Herstellungsablauf von Leiterbahnüberkreuzungen nach Variante 3 und 4 ergibt sich aus den in der Figur 2 wiedergegebenen Ablaufschemen.

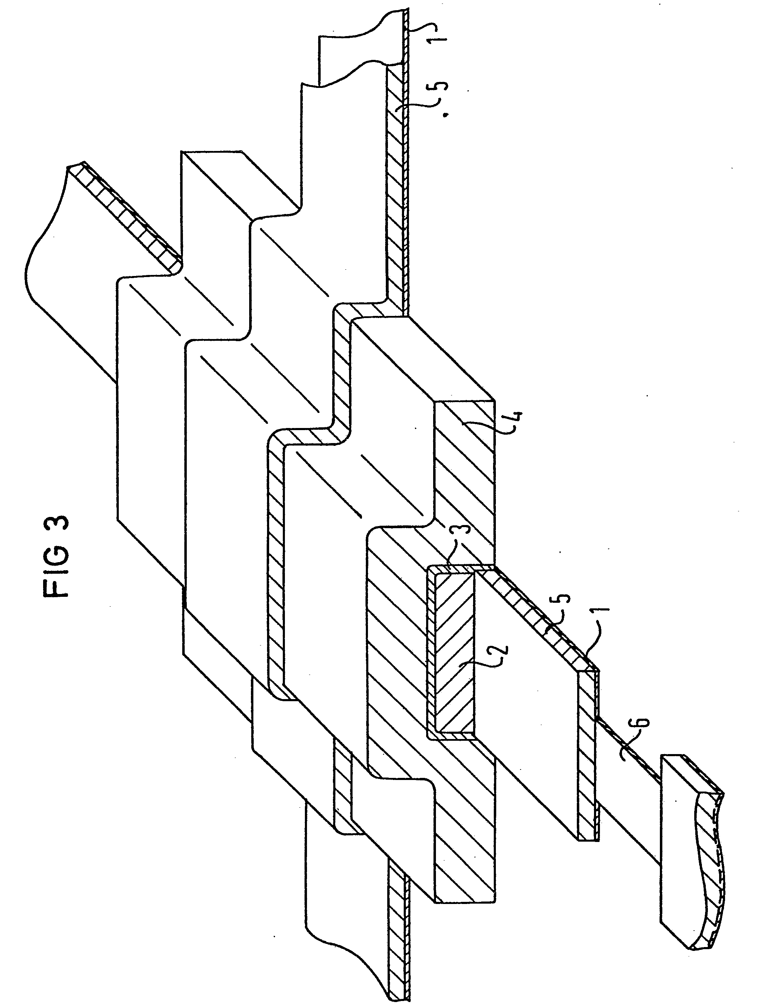

Die mit 1 bis 6 bezeichneten Strukturen nach der Figur 3 entsprechenden folgenden Schichten für die vier Varianten:

|   | Variante 1 | Variante 2 | Variante 3 | Variante 4 |
|---|------------|------------|------------|------------|
| 1 | TaAl I | TaAl I | TaAl I | TaAl I+II |
| 2 | TaAl I+II | TaAl I+II | TaAl I+II | TaAl I+II |
| 3 | TaAl-Oxyd | TaAl-Oxyd | TaAl-Oxyd | — |
| 4 | SiO$_2$ | SiO$_2$+Polyimid | Polyimid | Polyimid |
| 5 | TiPdAu | TiPdAu | TiPdAu | TiPdAu |
| 6 | TaAl I | TaAl I | TaAl I | TaAl I |

## Patentansprüche

1. Verfahren zur Herstellung von Leiterbahnüberkreuzungen geringer Kapazität in einer elektrischen Dünnschichtschaltung, bei dem auf ein isolierendes Substrat eine TaAl-Doppelschicht (6), deren untere TaAl-Schicht (TaAl I; 1) gegenüber der oberen TaAl-Schicht (TaAl II) einen höheren Ta-Gehalt aufweist, aufgebracht und durch einen ersten fotolithografischen Ätzschritt in Widerstände, in eine eine untere Kondensatorelektrode enthaltende untere Leiterbahn und in eine senkrecht dazu liegende Leiterbahn als Anschluß für eine obere Kondensatorelektrode strukturiert wird, bei dem anschließend nach Entfernen der ersten Fotolackmaske eine dielektrische Schicht (3, 4) aufgebracht und — vorzugsweise mit einem zweiten fotolithografischen Ätzschritt strukturiert wird, so daß zumindest die untere Kondensatorelektrode von der dielektrischen Schicht (3, 4) überdeckt bleibt, bei dem anschließend mit Hilfe der strukturierten dielektrischen Schicht als Maske die freiliegenden Teile der oberen TaAl-Schicht abgeätzt werden, und bei dem darauf eine Leiterbahnschicht (5) ganzflächig aufgebracht und mit Hilfe eines dritten fotolithografischen Ätzschrittes strukturiert wird, wobei die obere Kondensatorelektrode als Teil einer überkreuzenden Leiterbahn ausgebildet wird.

2. Verfahren nach Anspruch 1, dadurch gekennzeichnet, daß die untere Leiterbahn durch die vollkommen mit der unteren TaAl-Schicht unterlegten Leiterbahnschicht, die vorzugsweise aus Ti Pd Au besteht, und einem Stück der Ta Al-Doppelschicht im Überkreuzungsbereich gebildet wird und daß die überkreuzende Leiterbahn aus dem ebenfalls mit der unteren TaAl-Schicht unterlegten Leiterbahnschicht außerhalb und einem Stück der Leiterbahnschicht im Überkreuzungsbereich aufgebaut ist.

3. Verfahren nach Anspruch 1 oder 2, dadurch gekennzeichnet, daß die dielektrische Schicht durch anodische Oxidation der strukturierten Oberfläche der TaAl-Doppelschicht und anschließendes ganzflächiges Aufbringen einer $SiO_2$-Schicht hergestellt und durch einen fotolithografischen Ätzprozeß strukturiert wird.

4. Verfahren nach Anspruch 3, dadurch gekennzeichnet, daß vor dem Strukturieren der dielektrischen Schicht eine zusätzliche dielektrische Schicht, vorzugsweise aus Polyimid, im Überkreuzungsbereich aufgebracht wird.

5. Verfahren nach Anspruch 1 oder 2, dadurch gekennzeichnet, daß die dielektrische Schicht durch anodische Oxidation der strukturierten Oberfläche der TaAl-Doppelschicht und anschließendes Aufbringen einer Polyimidschicht hergestellt wird.

6. Verfahren nach Anspruch 1 oder 2, dadurch gekennzeichnet, daß die strukturierte dielektrische Schicht durch Aufbringen einer Polyimidschicht an den Überkreuzungsstellen hergestellt wird.

## Revendications

1. Procédé de fabrication de croisements de voies conductrices de capacité faible d'un circuit électrique intégré à couche mine, qui consiste à apporter sur un substrat isolant une couche (6) double en TaAl dont la couche inférieure en TaAl (TaAl I; 1) a une teneur en Ta plus élevée que la couche (TaAl II) supérieure en TaAl et, par un premier stade de décapage photolithographique, à structurer cette couche double en résistances, en une voie conductrice inférieure contenant une électrode inférieure de condensateur et en une voie conductrice perpendiculaire à la voie conductrice inférieure et servant de connexion pour une électrode de condensateur supérieure, à déposer, après avoir enlevé le premier masque de vernis photosensible, une couche (3, 4) diélectrique et de préférence à la structurer par un second stade de décapage photolithographique de manière à ce qu'au moins l'électrode inférieure de condensateur reste recouverte de la couche (3, 4) diélectrique, à enlever ensuite par décapage à l'aide de la couche diélectrique structurée et servant de masque les parties mises à nu de la couche supérieure en TaAl et à déposer sur toute la surface une couche (5) formant voie conductrice et à la structurer à l'aide d'un troisième stade de décapage photolitographique, l'électrode supérieure du condensateur constituant une partie d'une voie conductrice de croisement.

2. Procédé suivant la revendication 1, caractérisé en ce qu'il consiste à former, dans la région de croisement, la voie conductrice inférieure par une couche formant voie conductrice, sousjacente entièrement à la couche inférieure de TaAl et constituée de préférence en Ti Pd Au, et par une partie de la double couche en TaAl et à former la voie conductrice de croisement supérieure par la couche formant voie conductrice également sousjacente à la couche inférieure en TaAl en dehors de la région de croisement et par une partie de la couche formant voie conductrice dans la région de croisement.

3. Procédé suivant la revendication 1 ou 2, caractérisé en ce qu'il consiste à préparer la couche diélectrique par oxydation anodique de la surface structurée de la couche double en TaAl et ensuite par appart sur toute la surface d'une couche en $SiO_2$ et à structurer la couche diélectrique par un processus de décapage photolithographique.

4. Procédé suivant la revendication 3, caractérisé en ce qu'il consiste à déposer avant la structuration de la couche diélectrique une couche diélectrique supplémentaire, de préférence en polyamide dans la région de croisement.

5. Procédé suivant la revendication 1 ou 2, caractérisé en ce qu'il consiste à préparer la couche diélectrique par oxydation anodique de la surface structurée de la couche double en TaAl et ensuite par apport d'une couche de polyimide.

6. Procédé suivant la revendication 1 ou 2, caractérisé en ce qu'il consiste à préparer la couche diélectrique structurée par apport d'une couche de polyimide aux endroits de croisement.

### Claims

1. A process for the production of conductor path cross-overs of low capacitance in a thin-film electric circuit, wherein a Ta Al-double layer (6), the lower Ta Al-layer (TaAl I: 1) of which has a higher Ta-content than does the upper Ta Al-layer (TaAl: II), is applied to an insulating substrate and by means of a first photolithographic etching step, is structured to form resistors, a lower conductor path which includes a lower capacitor electrode, and a conductor path which is normal to the lower conductor path, and serves as a terminal for an upper capacitor electrode, and wherein, after the removal of the first photo-lacquer mask, a dielectric layer (3, 4) is subsequently formed and structured preferably by means of a second photolithographic etching step, so that at least the lower capacitor electrode remains covered by the dielectric layer (3, 4), wherein the exposed parts of the upper TaAl-layer, are subsequently etched away with the aid of the structured dielectric layer as a mask, and wherein a conductor path layer (5) is then applied to the overall surface and structured by means of a third photolithographic etching step, the upper capacitor electrode being designed as a part of an intersecting conductor path.

2. A process as claimed in Claim 1, characterised in that the lower conductor path is formed by the conductor path layer which is completely underlaid by the lower TaAl-layer and preferably consists of Ti, Pd, Au, and by a portion of the TaAl-double layer in the cross-over region, and that the crossing conductor path is constructed from the conductor path layer beyond, which is likewise underlaid by the lower TaAl-layer, and from a portion of the conductor path layer in the cross-over region.

3. A process as claimed in Claim 1 or Claim 2, characterised in that the dielectric layer is produced by anodic oxidation of the structured surface of the TaAl-double layer and by the subsequent application of an $SiO_2$-layer to the overall surface and its structuring by a photolithographic etching process.

4. A process as claimed in Claim 3, characterised in that, prior to the structuring of the dielectric layer, an additional dielectric layer, preferably consisting of a polyimide, is applied in the crossing region.

5. A process as claimed in Claim 1 or Claim 2, characterised in that the dielectric layer is produced by anodic oxidation of the structured surface of the TaAl-double layer and the subsequent application of a polyimide layer.

6. A process as claimed in Claim 1 or Claim 2, characterised in that the structured dielectric layer is produced by the application of a polyimide layer at the crossing points.

0 005 739

# FIG 1

```
┌─────────────────────────────────────┐
│  Aufbringen    Oxidunterlage         │
└─────────────────────────────────────┘
                   │
┌─────────────────────────────────────┐
│  Aufbringen    TaAl – Doppelsdicht   │
└─────────────────────────────────────┘
                   │
┌─────────────────────────────────────┐
│  Phototechnik I : Strukturieren      │
│     C-Elektrode,  Widerstand         │
│           Leiterbahnen               │
└─────────────────────────────────────┘
                   │
┌─────────────────────────────────────┐
│  Anod. Oxydation  (ganzflächig)      │
└─────────────────────────────────────┘
                   │
┌─────────────────────────────────────┐
│  Aufbringen   SiO2  (ganzflächig)    │
└─────────────────────────────────────┘
          /                 \
   VARIANTE 1            VARIANTE 2
                            │
                 ┌────────────────────────────────┐
                 │  Aufbringen  Jsolierschicht     │
                 │  (z.B. Polyimid  mit Siebdruck) │
                 └────────────────────────────────┘
          \                 /
┌─────────────────────────────────────────────┐
│  Phototechnik II : Strukturieren             │
│    Dielektrikum (SiO2 und  Ta Al-Oxid ätzen) │
└─────────────────────────────────────────────┘
                   │
┌─────────────────────────────────────┐
│  Selekt. Abätzen  des  Ta Al II – Rests │
└─────────────────────────────────────┘
                   │
┌─────────────────────────────────────┐
│  Aufbringen    Leiterbahn            │
└─────────────────────────────────────┘
                   │
┌─────────────────────────────────────┐
│  Phototechnik III  Strukturieren     │
│           Leiterbahn                 │
└─────────────────────────────────────┘
```

1

0 005 739

# FIG 2

Aufbringen Oxidunterlage

Aufbringen Ta Al-Doppelschicht

Phototechnik I: Strukturieren C-Elektrode, Widerstand Leiterbahn

Phototechnik I Strukturieren Widerstand, Leiterbahn

Anod.Oxydation (ganzflächig)

Aufbringen Jsolierschicht (z.B. Polyimid mit Siebdruck)

Aufbringen Jsolierschicht (z.B. Polyimid mit Siebdruck)

Phototechnik II Strukturieren Dielektrikum (Ta Al Oxid ätzen)

Selekt. Abätzen des Ta Al II- Rests

Aufbringen Leiterbahn

Aufbringen Leiterbahn

Phototechnik III Strukturieren Leiterbahn

Phototechnik II : Strukturieren Leiterbahn

Selekt. Abätzen von Ta Al II

VARIANTE 3
(Ta Al RC-Netzwerk-nicht temperaturkompensiert-mit Ta Al-Oxid/ Polyimid -Leiter- bahnüberkreuzungen )

VARIANTE 4
(Ta Al-R-Netzwerk mit Polyimid- Leiterbahnüberkreuzungen )

2

FIG 3

0005 739